(19) Europäisches Patentamt
European Patent Office
Office européen des brevets

(11) **EP 4 563 554 A1**

(12) **EUROPÄISCHE PATENTANMELDUNG**

(43) Veröffentlichungstag:
**04.06.2025  Patentblatt 2025/23**

(21) Anmeldenummer: **24214378.2**

(22) Anmeldetag: **21.11.2024**

(51) Internationale Patentklassifikation (IPC):
**C04B 37/02** (2006.01)     **C04B 41/53** (2006.01)
**H01L 21/306** (2006.01)     **C04B 41/00** (2006.01)
**C04B 41/91** (2006.01)

(52) Gemeinsame Patentklassifikation (CPC):
(C-Sets verfügbar)
**C04B 37/026; C04B 41/0036; C04B 41/009;
C04B 41/5346; C04B 41/5353; C04B 41/91;
H05K 3/00;** C04B 2237/366; C04B 2237/368;
C04B 2237/402; C04B 2237/407          (Forts.)

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(30) Priorität: **30.11.2023  EP 23213369**

(71) Anmelder: **Heraeus Electronics GmbH & Co. KG
63450 Hanau (DE)**

(72) Erfinder:
• **Wacker, Richard
63450 Hanau (DE)**
• **Schlüter, Bastian
63450 Hanau (DE)**
• **Schnee, Daniel
63450 Hanau (DE)**

(74) Vertreter: **Heraeus IP
Heraeus Business Solutions GmbH
Intellectual Property
Heraeusstraße 12-14
63450 Hanau (DE)**

(54) **VERFAHREN ZUR STRUKTURIERUNG EINES METALL-KERAMIK-VERBUNDS**

(57)    Die vorliegende Erfindung betrifft ein Verfahren zur Strukturierung eines Metall-Keramik-Verbunds, das folgende Schritte umfasst:
- Bereitstellung eines Metall-Keramik-Verbunds, enthaltend
- ein Nitridkeramiksubstrat, das eine Vorderseite und eine Rückseite aufweist,
- eine auf der Vorderseite des Nitridkeramiksubstrats vorliegende Metallbeschichtung,
- eine Reaktionsschicht, die zwischen der Metallbeschichtung und dem Keramiksubstrat vorliegt und ein oder mehrere Elemente $E_{RS}$, ausgewählt aus Ti, Hf, Zr, Nb, V, Ta und Ce, enthält,

- Abtragen der Metallbeschichtung, so dass mindestens eine Aussparung in der Metallbeschichtung erzeugt wird und eine freigelegte Haftvermittlungsschicht in der Aussparung vorliegt,
- Abtragen der freigelegten Reaktionsschicht mit einem gepulsten Laserstrahl eines Ultrakurzpulslasers, so dass eine freigelegte Oberfläche des Keramiksubstrats in der Aussparung vorliegt, wobei der gepulste Laserstrahl eine Gesamtfluenz von 50 J/cm$^2$ bis 650 J/cm$^2$ appliziert.

**EP 4 563 554 A1**

(52) Gemeinsame Patentklassifikation (CPC): (Forts.)

C-Sets
**C04B 41/009, C04B 35/581**

**Beschreibung**

Die vorliegende Erfindung betrifft ein Verfahren zur Strukturierung eines Metall-Keramik-Verbunds. Solche strukturierten Metall-Keramik-Verbunde sind als keramische Schaltungsträger in Halbleitermodulen der Leistungselektronik verwendbar.

In der Leistungselektronik müssen Leiterplatten als Träger von Leistungsbauteilen wie MOSFETs für hohe Ströme ausgelegt sein und Verlustwärme schnell abführen können.

Da keramische Materialien wie Aluminiumoxid, Aluminiumnitrid und Siliziumnitrid gegenüber Polymeren, die für die Herstellung herkömmlicher Leiterplatten verwendet werden, eine wesentlich höhere Wärmeleitfähigkeit aufweisen, werden in Leistungsmodulen häufig keramische Schaltungsträger verwendet.

Ein keramischer Schaltungsträger enthält ein Keramiksubstrat, das zumindest auf seiner Vorderseite mit einer Metallschicht versehen ist. Üblicherweise wird auch auf der Rückseite des Keramiksubstrats eine Metallschicht aufgebracht. Auf einer dieser Metallschichten sind im finalen Modul die Halbleiterbauelemente aufgebracht, während die Metallschicht auf der gegenüberliegenden Seite des Keramiksubstrats thermisch leitend mit einem Kühlkörper verbunden ist. Durch das Keramiksubstrat sind die Metallschichten elektrisch isoliert voneinander.

Die dem Fachmann bekannte Herstellung eines als keramische Leiterplatte fungierenden metallisierten Keramiksubstrats erfolgt beispielsweise, indem die Vorder- und Rückseite des Keramiksubstrats jeweils mit einer Metallfolie (z.B. einer Kupfer- oder Aluminiumfolie) in Kontakt gebracht und stoffschlüssig verbunden werden.

In einem dieser dem Fachmann bekannten Verfahren wird die Metallfolie durch ein eutektisches Bonden stoffschlüssig mit dem Keramiksubstrat verbunden. Ist die Metallfolie eine Kupferfolie, so wird das eutektische Bonding auch als DCB- oder DBC-Verfahren bezeichnet (DCB: *"Direct Copper Bonding"*; DBC: *"Direct Bonded Copper"*). Im Fall einer Aluminiumfolie wird beim eutektischen Bonding auch die Bezeichnung "DAB" ("*Direct Aluminum Bonding*") verwendet. Ein über ein DCB-Verfahren hergestelltes metallisiertes Keramiksubstrat wird gelegentlich auch als DCB-Substrat (alternativ: DBC-Substrat) bezeichnet.

Keramiksubstrate auf Basis eines Nitrids (Nitridkeramiksubstrate) wie z.B. Aluminium- oder Siliziumnitrid finden aufgrund ihrer vorteilhaften Eigenschaften Verwendung als keramische Schaltungsträger.

So weisen Keramiksubstrate auf der Basis von Siliziumnitrid beispielsweise eine sehr hohe mechanische Festigkeit bei gleichzeitig hoher Wärmeleitfähigkeit auf und sind daher sehr gut für Anwendungen in der Leistungselektronik geeignet.

Keramiksubstrate auf der Basis von Siliziumnitrid werden beispielsweise in folgenden Publikationen beschrieben:

N. Chasserio et al., "Ceramic Substrates for High-Temperature Electronic Integration", Journal of Electronic Materials, Band 38 (2009), S. 164-174;

K. Hirao et al., "High Thermal Conductivity Silicon Nitride Ceramics", Journal of the Korean Ceramic Society, Band 49 (2012), S. 380-384;

Y. Zhou et al., "Development of high-thermal-conductivity silicon nitride ceramics", Journal of Asian Ceramic Societies, 3 (2015), S. 221-229.

Keramiksubstrate auf der Basis von Aluminiumnitrid weisen eine sehr hohe Wärmeleitfähigkeit bei gleichzeitig ausreichend hoher mechanischer Festigkeit auf und sind daher ebenfalls sehr gut für Anwendungen in der Leistungselektronik geeignet.

Für eine Metallisierung über das DCB-Verfahren sind jedoch Siliziumnitridsubstrate nicht geeignet und Aluminiumnitridsubstrate müssen zunächst oberflächlich oxidiert werden, was jedoch aufwändig ist und die Wärmeleitfähigkeit nachteilig beeinflussen kann.

Die Metallisierung von Nitridkeramiken erfolgt daher häufig über ein Aktivlöten (englisch: "*active metal brazing*", AMB).

Aktivlote sind metallische Lote, die aufgrund ihrer Zusammensetzung in der Lage sind, nichtmetallische, anorganische Werkstoffe (z. B. Keramik, Graphit, Glas) zu benetzen. Aktivlote enthalten neben einer Hauptkomponente wie z.B. Cu, Ag oder Au ein oder mehrere Elemente, die mit der Keramik unter Ausbildung einer haftvermittelnden Reaktionsschicht reagieren können (siehe z.B. Kapitel 8.2.4.3 ("Aktivlöten"), Seiten 203-204, in Brevier Technische Keramik, Verband der Keramischen Industrie e.V., 2003, Fahner Verlag). Als reaktive Elemente kommen beispielsweise Hafnium (Hf), Titan (Ti), Zirkonium (Zr), Niob (Nb), Cer (Ce), Tantal (Ta) und Vanadium (V) zum Einsatz. Bei der Metallisierung von Siliziumnitridsubstraten durch Aktivlöten enthält die Reaktionsschicht beispielsweise ein Nitrid, Oxynitrid und/oder Silicid des reaktiven Elements (A. Pönicke et al., "Aktivlöten von Kupfer mit Aluminiumnitrid- und Siliziumnitridkeramik", Keramische Zeitschrift, 63(5), 2011, 334-342).

Die die Halbleiterbauelemente tragende Metallbeschichtung des Metall-Keramik-Verbunds ist strukturiert (z.B. durch ein Ätzen unter Verwendung einer Ätzmaske). Eine strukturierte Metallbeschichtung weist also eine oder mehrere Aussparungen auf, durch die die nach der Strukturierung verbliebenen Bereiche der Metallbeschichtung voneinander separiert sind. Die Strukturierung von AMB-Substraten erfolgt üblicherweise in einem zweistufigen Verfahren. Beispielsweise wird in einem ersten Schritt eine erste Ätzlösung verwendet, die hinsichtlich des Abtragens der Metallbeschichtung optimiert ist. Mit dieser ersten Ätzlösung wird in definierten (z.B. nicht maskierten) Bereichen die Metallbeschichtung abgetragen und die beim Aktivlöten gebildete Reaktionsschicht freigelegt. In einem weiteren Schritt wird mit einer zweiten Ätzlösung, die hinsichtlich des Abtragens der Reaktionsschicht optimiert ist, die Oberfläche des Keramiksubstrats freigelegt.

Für die spätere Verwendung als Leistungselektronikmodul ist es wesentlich, dass benachbarte Leiterbahnen, die durch die Strukturierung ausgebildet wurden, elektrisch isoliert voneinander sind. Dies wiederum setzt voraus, dass zwischen benachbarten Leiterbahnen keine Rückstände der Reaktionsschicht verblieben sind. Die im zweiten Ätzschritt verwendete Ätzlösung sollte daher die freiliegende Reaktionsschicht vollständig entfernen. Dabei kommt es jedoch häufig zu einer Unterätzung der Metallbeschichtung, d.h. die Ätzlösung des zweiten Ätzschritts trägt nicht nur die nach dem ersten Ätzschritt freigelegte Reaktionsschicht ab, sondern entfernt außerdem an der Flanke der Metallbeschichtung eine noch bedeckte und damit eine für die Bindung zwischen Metallbeschichtung und Keramiksubstrat benötigte Reaktionsschicht. Dies kann unter Temperaturwechselbelastungen zu einer Ablösung der Metallbeschichtung vom Keramiksubstrat führen.

Für das Ätzen der aus dem Aktivlotverfahren resultierenden Reaktionsschicht werden aggressive Chemikalien benötigt, die selbst nach einem abschließenden Waschschritt unerwünschte (z.B. korrosive) Rückstände auf der Keramik hinterlassen können. So können bei der Verwendung fluoridhaltiger Ätzmedien Fluoridrückstände auf der freigelegten Keramikoberfläche verbleiben. Solche Ätzmittelrückstände können in einem Leistungselektronikmodul eine korrosive Wirkung entfalten.

Bei dem Versuch, die nach dem ersten Abtragungsschritt freigelegte Reaktionsschicht in einem weiteren Abtragungsschritt möglichst vollständig zu entfernen, besteht grundsätzlich das Risiko, das Keramiksubstrat zu schädigen. Dies wiederum kann zu einer Beeinträchtigung der mechanischen Eigenschaften, beispielsweise der Biegebruchfestigkeit des Keramiksubstrats führen.

Eine Aufgabe der vorliegenden Erfindung ist die Strukturierung eines durch Aktivlöten hergestellten Metall-Keramik-Verbunds durch ein Verfahren, das in definierten Bereichen eine effiziente Freilegung der Keramikoberfläche ermöglicht, dies jedoch nicht auf Kosten der Temperaturwechselbeständigkeit des Metall-Keramik-Verbunds und/oder der mechanischen Eigenschaften wie z.B. der Biegebruchfestigkeit des Keramiksubstrats realisiert. Eine effiziente Freilegung der Keramikoberfläche beinhaltet insbesondere, dass auf der freigelegten Keramiksubstratoberfläche im Wesentlichen keine elektrisch leitfähigen und/oder korrosiv wirkenden Materialien verblieben sind.

Gelöst wird die Aufgabe durch ein Verfahren zur Strukturierung eines Metall-Keramik-Verbunds, das folgende Schritte umfasst:

- Bereitstellung eines Metall-Keramik-Verbunds, enthaltend

    - ein Nitridkeramiksubstrat, das eine Vorderseite und eine Rückseite aufweist,
    - eine auf der Vorderseite des Nitridkeramiksubstrats vorliegende Metallbeschichtung,
    - eine Reaktionsschicht, die zwischen der Metallbeschichtung und dem Keramiksubstrat vorliegt und ein oder mehrere Elemente $E_{RS}$, ausgewählt aus Ti, Hf, Zr, Nb, V, Ta und Ce, enthält,

- Abtragen der Metallbeschichtung, so dass mindestens eine Aussparung in der Metallbeschichtung erzeugt wird und eine freigelegte Haftvermittlungsschicht in der Aussparung vorliegt,
- Abtragen der freigelegten Reaktionsschicht mit einem gepulsten Laserstrahl eines Ultrakurzpulslasers, so dass eine freigelegte Oberfläche des Keramiksubstrats in der Aussparung vorliegt, wobei der gepulste Laserstrahl eine Gesamtfluenz von 50 $J/cm^2$ bis 650 $J/cm^2$ appliziert.

Der Metall-Keramik-Verbund, der in dem erfindungsgemäßen Verfahren durch ein in definierten Bereichen erfolgendes Freilegen der Keramikoberfläche strukturiert wird, ist ein über Aktivlöten hergestellter Metall-Keramik-Verbund, wobei die Keramik eine Nitridkeramik ist. Solche Metall-Keramik-Verbunde sind dem Fachmann bekannt und kommerziell erhältlich oder durch bekannte Verfahren herstellbar. Auch das Abtragen der Metallbeschichtung unter Freilegung der aus dem Aktivlöten resultierenden Reaktionsschicht kann unter Verwendung üblicher Abtragungsmethoden (beispielsweise Ätzen) erfolgen, wie nachfolgend noch ausführlicher dargelegt wird.

In der vorliegenden Erfindung wurde erkannt, dass die freigelegte Reaktionsschicht sich vollständig von der Oberfläche des Keramiksubstrats abtragen lässt und die Biegebruchfestigkeit des Keramiksubstrats sowie die Temperaturwechselbeständigkeit des Metall-Keramik-Verbunds dennoch auf einem hohen Niveau gehalten werden können, wenn die Abtragung mit einem Ultrakurzpulslaser erfolgt und die von dem Ultrakurzpulslaser für die Freilegung des Keramiksubstrats applizierte Gesamtfluenz 50 $J/cm^2$ bis 650 $J/cm^2$ beträgt.

Ein Ultrakurzpulslaser ist ein Laser, der Laserpulse mit einer Pulsdauer im Bereich von Pikosekunden ("Pikosekundenlaser") oder Femtosekunden ("Femtosekundenlaser") emittieren kann. Wie dem Fachmann bekannt ist, bezeichnet die Fluenz (oder Energiedichte) eines Lasers die pro Flächeneinheit applizierte Energie. Bei einem gepulsten Laserstrahl kann sich die Fluenz auf einen einzelnen Laserpuls oder die Gesamtheit aller während der Bearbeitung eines Materials abgegebenen Laserpulse beziehen. Letztere wird als Gesamtfluenz oder akkumulierte Fluenz (englisch: "accumulated fluence") bezeichnet und bezieht sich auf die gesamte Energie pro Flächeneinheit, die durch den gepulsten Laserstrahl in den bestrahlten Bereich des Metall-Keramik-Verbunds appliziert wurde.

Die Gesamtfluenz $F_{total}$ ergibt sich aus folgender Beziehung:

$$F_{total} = E_{total} / A_L$$

wobei

$E_{total}$ die vom gepulsten Laserstrahl insgesamt applizierte Energie ist und
$A_L$ die von dem Laserstrahl bestrahlte Gesamtfläche ist.

Sofern die Laserpulse des gepulsten Laserstrahls jeweils die gleiche Pulsenergie EP aufweisen, ergibt sich die Gesamtfluenz Ftotal aus folgender Beziehung:

$$F_{total} = N_P \times E_P / A_L$$

wobei

$N_P$ die Gesamtzahl der von dem gepulsten Laserstrahl applizierten Laserpulse ist,
$E_P$ die Energie eines Laserpulses ist,
$A_L$ die von dem Laserstrahl bestrahlte Gesamtfläche ist.

Wie nachfolgend noch eingehender beschrieben, wird bei einer durch den gepulsten Laserstrahl des Ultrakurzpulslasers applizierten Gesamtfluenz von weniger als 50 J/cm$^2$ die freigelegte Reaktionsschicht nicht oder nur ungenügend abgetragen, während bei einer applizierten Gesamtfluenz von mehr als 650 J/cm$^2$ die freigelegte Reaktionsschicht zwar vollständig entfernt wird, die Biegebruchfestigkeit des Keramiksubstrats sich jedoch signifikant verschlechtert.

Der in dem erfindungsgemäßen Verfahren zu strukturierende Metall-Keramik-Verbund enthält

- ein Nitridkeramiksubstrat, das eine Vorderseite und eine Rückseite aufweist,
- eine auf der Vorderseite des Nitridkeramiksubstrats vorliegende Metallbeschichtung und
- eine Reaktionsschicht, die zwischen der Metallbeschichtung und dem Keramiksubstrat vorliegt und ein oder mehrere Elemente $E_{RS}$, ausgewählt aus Ti, Hf, Zr, Nb, V, Ta und Ce, enthält.

Das Nitridkeramiksubstrat enthält beispielsweise ein Siliziumnitrid oder ein Aluminiumnitrid. In einer bevorzugten Ausführungsform enthält das Nitridkeramiksubstrat Siliziumnitrid.

Beispielsweise enthält das Nitridkeramiksubstrat das Siliziumnitrid oder Aluminiumnitrid in einem Anteil von mindestens 70 Gew%, bevorzugter mindestens 80 Gew%.

Optional kann das Nitridkeramiksubstrat noch ein oder mehrere Metalloxide enthalten. Diese wurden beispielsweise während der Herstellung des Keramiksubstrats als Sinterhilfsmittel zugegeben. Beispielsweise enthält das Nitridkeramiksubstrat eines oder mehrere der folgenden Oxide: Ein oder mehrere Erdalkalimetalloxide wie z.B. Magnesiumoxid, ein oder mehrere Übergangsmetalloxide (z.B. ein oder mehrere Seltenerdoxide wie Yttriumoxid), ein Siliziumoxid (z.B. SiOz) oder ein Silikat.

Das Nitridkeramiksubstrat weist beispielsweise eine Dicke im Bereich von 0,1 mm bis 1,0 mm auf.

Auf der Vorderseite des Nitridkeramiksubstrats liegt eine Metallbeschichtung vor. Optional liegt auf der Rückseite des Keramiksubstrats ebenfalls eine Metallbeschichtung vor.

Die auf der Vorderseite und optional der Rückseite des Nitridkeramiksubstrats vorliegende Metallbeschichtung ist beispielsweise eine Kupferbeschichtung oder eine Aluminiumbeschichtung. Die Metallbeschichtung weist beispielsweise eine Dicke im Bereich von 0,05 mm bis 1,5 mm, bevorzugter 0,2 mm bis 0,8 mm auf.

Sofern die Metallbeschichtung eine Kupferbeschichtung ist, weist diese beispielsweise einen Kupfergehalt von mindestens 97 Gew%, bevorzugter mindestens 99 Gew% auf.

Sofern die Metallbeschichtung eine Aluminiumbeschichtung ist, weist diese beispielsweise einen Aluminiumgehalt von mindestens 97 Gew%, bevorzugter mindestens 99 Gew% auf.

Die Metallbeschichtung ist beispielsweise eine Kupferfolie oder eine Aluminiumfolie, die durch ein Aktivlöten auf das Nitridkeramiksubstrat aufgebracht wurde.

Die Reaktionsschicht enthält ein oder mehrere Elemente $E_{RS}$, ausgewählt aus Hf, Ti, Zr, Nb, V, Ta und Ce, bevorzugt ausgewählt aus Hf, Ti, Zr, Nb und Ce, bevorzugter ausgewählt aus Hf, Ti und Zr. Besonders bevorzugt ist das Element $E_{RS}$ in der Reaktionsschicht Titan. Beispielsweise liegen die Elemente $E_{RS}$ in der Reaktionsschicht in Form eines Nitrids, Oxynitrids und/oder Silicids vor. Beispielsweise enthält die Reaktionsschicht die Elemente $E_{RS}$ in einer Gesamtmenge von mindestens 50 Gew%. Beispielsweise enthält die Reaktionsschicht die Nitride, Oxynitride und Silicide der Elemente $E_{SR}$ in einer Gesamtmenge von mindestens 70 Gew%, bevorzugter mindestens 85 Gew%. In einem Halbleitermodul der Leistungselektronik kann die Migration von Silber zu Problemen führen. Es kann daher bevorzugt sein, dass die Reaktionsschicht Silber in einem Anteil von nicht mehr als 5 Gew%, bevorzugter nicht mehr als 1 Gew% enthält oder sogar silberfrei ist.

In dem erfindungsgemäßen Verfahren wird die Metallbeschichtung des bereitgestellten Metall-Keramik-Verbunds in definierten Bereichen (z.B. unter Berücksichtigung einer bestimmten angestrebten Leiterbahnenanordnung) abgetragen, so dass mindestens eine Aussparung in der Metallbeschichtung erzeugt wird und eine freigelegte Reaktionsschicht in der Aussparung vorliegt.

Das Abtragen der Metallbeschichtung unter Ausbildung einer oder mehrerer Aussparungen in der Metallbeschichtung kann durch Verfahren erfolgen, die dem Fachmann bekannt sind.

Beispielsweise erfolgt das Abtragen der Metallbeschichtung durch ein Ätzen (z.B. unter Verwendung einer Ätzmaske, so dass die Metallbeschichtung nur in den nicht maskierten Bereichen mit dem Ätzmedium in Kontakt kommt und abgetragen wird) oder eine Laserablation.

In einer bevorzugten Ausführungsform erfolgt das Abtragen der Metallbeschichtung durch ein Ätzen. Geeignete Ätzmedien und Ätzbedingungen für das Abtragen einer Metallbeschichtung (beispielsweise einer Kupfer- oder Aluminiumbeschichtung) sind dem Fachmann bekannt. Beispielsweise erfolgt das Ätzen mit einer wässrigen Metallchloridlösung (z.B. einer wässrigen Eisenchlorid- oder Kupferchloridlösung). Es können aber auch andere, dem Fachmann bekannte Ätzlösungen verwendet werden. Das Ätzen kann gegebenenfalls in mehreren Schritten unter Verwendung unterschiedlicher Ätzlösungen erfolgen. Das Ätzen erfolgt so lange, bis die Reaktionsschicht freigelegt ist. Hinsichtlich der Zusammensetzung der freigelegten Reaktionsschicht kann auf die obigen Ausführungen verwiesen werden.

Die in der Aussparung vorliegende freigelegte Reaktionsschicht wird mit einem gepulsten Laserstrahl eines Ultrakurzpulslasers bestrahlt und abgetragen, so dass eine Oberfläche des Keramiksubstrats in der Aussparung freigelegt wird. Die Freilegung der Oberfläche des Keramiksubstrats erfolgt mit einer durch den gepulsten Laserstrahl applizierten Gesamtfluenz von 50 J/cm$^2$ bis 650 J/cm$^2$. Mit dieser applizierten Gesamtfluenz lässt sich die freigelegte Reaktionsschicht vollständig von der Oberfläche des Keramiksubstrats abtragen, ohne dass dies zu einer Beeinträchtigung der Biegebruchfestigkeit des Keramiksubstrats oder der Temperaturwechselbeständigkeit des Metall-Keramik-Verbunds führt.

In einer beispielhaften Ausführungsform beträgt die durch den gepulsten Laserstrahl applizierte Gesamtfluenz 100 J/cm$^2$ bis 320 J/cm$^2$.

Der gepulste Laserstrahl des Ultrakurzpulslasers weist beispielsweise Laserpulse mit einer Pulsdauer im Bereich von Pikosekunden ("Pikosekundenlaser") oder Femtosekunden ("Femtosekundenlaser") auf. Beispielsweise beträgt die Pulsdauer 1 fs bis 100 ps, bevorzugter 100 fs bis 50 ps (z.B. 1 bis 100 ps, bevorzugter 1 bis 50 ps, oder 1 bis < 1000 fs, bevorzugter 100 bis < 1000 fs).

Geeignete Laserbetriebsparameter, mit denen sich die applizierte Gesamtfluenz einstellen lässt, sind dem Fachmann bekannt.

Wie oben bereits erwähnt, ergibt sich die Gesamtfluenz, die durch den gepulsten Laserstrahl appliziert wurde, aus der durch den gepulsten Laserstrahl eingebrachten Gesamtenergie pro Einheitsfläche.

Beispielsweise lässt sich die durch den gepulsten Laserstrahl applizierte Gesamtfluenz durch einen oder mehrere der folgenden Parameter einstellen:

- Energie eines Laserpulses,
- Pulsfrequenz (d.h. Anzahl der Laserpulse pro Zeiteinheit)
- Durchmesser des Laserstrahls, der auf die Oberfläche des abzutragenden Materials auftrifft,
- Ausmaß der räumlichen Überlappung der Laserpulse (z.B. die räumliche Überlappung aufeinanderfolgender Laserpulse entlang einer Scanlinie oder die räumliche Überlappung zwischen Laserpulsen benachbarter Scanlinien),
- Anzahl der Laserüberfahrten über das abzutragende Material,
- Scangeschwindigkeit (d.h. die Geschwindigkeit, mit der der gepulste Laserstrahl über das abzutragende Material geführt wird).

Diese Parameter lassen sich an kommerziell erhältlichen Ultrakurzpulslasern durch dem Fachmann bekannte Maßnahmen einstellen und variieren.

Beispielsweise weisen die Pulse des gepulsten Laserstrahls jeweils eine Pulsenergie von mindestens 15 μJ, bevorzugter mindestens 20 μJ, beispielsweise 15 μJ bis 300 μJ, bevorzugter 20 μJ bis 200 μJ auf.

Beispielsweise weist der gepulste Laserstrahl eine Pulsfrequenz von 100 kHz bis 50 MHz, bevorzugter 500 kHz bis 20 MHz auf.

Der auf die freigelegte Haftvermittlungsschicht auftreffende gepulste Laserstrahl weist beispielsweise einen Durchmesser von 3 μm bis 200 μm, bevorzugter 10 μm bis 100 μm auf.

Der Durchmesser des auf die freigelegte Reaktionsschicht treffenden gepulsten Laserstrahls kann über den Fokusdurchmesser des Laserstrahls eingestellt werden. Beispielsweise weist der gepulste Laserstrahl einen Fokus-durchmesser von 3 μm bis 200 μm, bevorzugter 10 μm bis 100 μm auf und der Metall-Keramik-Verbund wird so positioniert, dass die freigelegte Reaktionsschicht im Fokus des gepulsten Laserstrahls liegt.

Der gepulste Laserstrahl wird beispielsweise entlang einer oder mehrerer Scanlinien (auch als Bearbeitungslinien oder Bearbeitungsbahnen bezeichnet) über die freigelegte und abzutragende Haftvermittlungsschicht geführt.

Bevorzugt sind die Pulsfrequenz und die Scangeschwindigkeit des gepulsten Laserstrahls so gewählt, dass sich unmittelbar aufeinanderfolgende Laserpulse räumlich überlappen (d.h. die Auftreffflächen der unmittelbar aufeinanderfolgenden Laserpulse auf der freigelegten Haftvermittlungsschicht überlappen miteinander).

Der Pulsüberlapp PÜ wird üblicherweise in % angegeben und kann beispielsweise durch folgende Gleichung berechnet werden:

$$PÜ = (1 - v_{scan} / (D_L \times f_L)) \times 100\%$$

wobei

$v_{scan}$ die Scangeschwindigkeit des gepulsten Laserstrahls ist (d.h. die Geschwindigkeit, mit der der gepulste Laserstrahl über die freigelegte Haftvermittlungsschicht geführt wird),
$D_L$ der Durchmesser des auf die freigelegte Haftvermittlungsschicht treffenden gepulsten Laserstrahls ist,
$f_L$ die Pulsfrequenz des gepulsten Laserstrahls ist.

Der Pulsüberlapp PÜ kann bei vorgegebenem Laserstrahldurchmesser durch Pulsfrequenz und Scangeschwindigkeit des gepulsten Laserstrahls eingestellt werden.

Beispielsweise wird in dem Verfahren der vorliegenden Erfindung ein Pulsüberlapp von mindestens 60%, bevorzugter mindestens 80% gewählt.

Es gilt also beispielsweise folgende Beziehung:

$$PÜ = (1 - v_{scan} / (D_L \times f_L)) \times 100\% \geq 60\%$$

Bevorzugter gilt:

$$PÜ = (1 - v_{scan} / (D_L \times f_L)) \times 100\% \geq 80\%$$

Nach der Freilegung der Vorderseite des Keramiksubstrats in der mindestens einen Aussparung kann der strukturierte Metall-Keramik-Verbund gegebenenfalls noch weiteren Behandlungsschritten unterzogen werden. Beispielsweise können auf der strukturierten Metallbeschichtung Halbleiterbauelemente und/oder metallische Bonddrähte aufgebracht werden.

**Messmethoden**

Zusammensetzung der Reaktionsschicht

Die Zusammensetzung der Haftvermittlungsschicht wird durch eine energiedispersive Röntgenspektroskopie (EDX), gekoppelt mit Rasterelektronenmikroskopie, bestimmt (REM-EDX).

Bei REM-EDX wird ein fokussierter Primär-Elektronenstrahl punktweise über die Probenoberfläche geführt (gerastert). Die gestreuten Elektronen werden mit einem Detektor erfasst, wobei die Elektronenzahl pro Bildpunkt ein mikroskopisches Abbild der Probenoberfläche in Graustufen ergibt. Zusätzlich regt der Primär-Elektronenstrahl die Probe zur Emission von charakteristischer Röntgenstrahlung an, wobei die Elemente in der Probe und deren Gewichtsanteil durch die Analyse des Energiespektrums mit einem EDX-Detektor bestimmt werden kann. Für die Untersuchung wird beispielsweise ein RasterElektronenmikroskop (JSM-6060 SEM, JEOL Ltd) mit einem Silizium Drift EDX Detektor (NORAN, Thermo Scientific Inc) und einer Analysesoftware (Pathfinder Mountaineer EDS System, zum Beispiel Version 2.8, Thermo Scientific Inc) verwendet. Für die RasterElektronenmikroskopie werden folgende Einstellungen verwendet: Vergrößerung: 1000fach, Beschleunigungsspannung = 15 kV, Arbeitsabstand = 10 mm, Spotgröße (50 - 60) (eingestellt, um 25% +/- 5% der Totzeit des EDX-Detektors zu erreichen). Das EDX-Spektrum wurde unter Verwendung der folgenden Einstellungen des EDX-Detektors erfasst: Live Time = 30 s, Rate = auto, Low Energy Cutoff = 100 keV, High Energy Cutoff = Auto (per REM-Beschleunigungsspannung).

Durch REM-EDX lässt sich die Zusammensetzung der Reaktionsschicht sowohl in qualitativer Hinsicht (Detektion bestimmter Elemente und Phasen, z.B. eine in der Haftvermittlungsschicht vorliegende Metallnitridphase) als auch quantitativ bestimmen. Die Messung wird beispielsweise an mindestens 10 Stellen der Reaktionsschicht durchgeführt.

**Beispiele**

In den nachfolgend beschriebenen Beispielen wurden zunächst übereinstimmende Siliziumnitridsubstrate unter identischen Bedingungen durch ein Aktivlöten mit einer Kupferfolie unter Erhalt eines Kupfer-Siliziumnitrid-Verbunds metallisiert.

Die Metallisierung der Siliziumnitridsubstrate durch Aktivlöten erfolgte folgendermaßen: Auf einer der Seiten des Keramiksubstrats wurde auf einer Fläche der Abmessung 168 mm x 130 mm eine Aktivlotpaste durch Siebdruck aufgebracht und für 15 Minuten bei 125°C vorgetrocknet. Die Aktivlotpaste bestand aus 67 Gewichtsprozent Kupferpulver, 19,8 Gewichtsprozent Zinnpulver und 3,7 Gewichtsprozent Titanhydrid und 9,5 Gewichtsprozent eines organischen Vehikels. Die Pastendicke nach der Vortrocknung betrug 25 +/- 5 $\mu$m. Anschließend wurde eine Kupferfolie aus sauerstofffreiem, hochleitfähigem Kupfer mit einer Reinheit von 99,99% und einer Abmessung von 170 mm x 132 mm x 0.3 mm auf die vorgetrocknete Paste gelegt. Danach wurde die so erzeugte Anordnung herumgedreht, die Paste gleichermaßen auf die gegenüberliegende Seite des Keramiksubstrats durch Siebdruck aufgebracht, vorgetrocknet und mit einer Kupferfolie bestückt, um eine Sandwichanordnung zu erhalten. Die Sandwichanordnung wurde mit einem Gewicht von 1 kg beschwert, bei einer Höchsttemperatur von 910°C für 20 Minuten gebrannt und anschließend auf Raumtemperatur abgekühlt, um einen unstrukturierten Metall-Keramik-Verbund zu erhalten. Aufgrund der Herstellung durch ein Aktivlöten liegt zwischen der Metallbeschichtung und dem Keramiksubstrat eine haftvermittelnde Reaktionsschicht vor. Diese enthält Titan (z.B. in Form eines Nitrids).

Anschließend wurde in jedem der bereitgestellten Metall-Keramik-Verbunde die Metallbeschichtung in definierten Bereich unter identischen Bedingungen abgetragen, so dass in jedem der Metall-Keramik-Verbunde mindestens eine Aussparung in der Metallbeschichtung erzeugt wurde und eine freigelegte Reaktionsschicht in der Aussparung vorlag. Das Abtragen der Kupferbeschichtung erfolgte jeweils mit einer $CuCl_2$-haltigen Ätzlösung.

Die nach dem Ätzen auf dem Keramiksubstrat verbliebene freigelegte Reaktionsschicht wurde anschließend unter unterschiedlichen Bedingungen entfernt.

In den erfindungsgemäßen Beispielen EB-1.1, EB-1.2, EB-1.3, EB-1.4 und EB-1.5 sowie den Vergleichsbeispielen VB-1.1, VB-1.2 und VB-1.3 wurde die freigelegte Reaktionsschicht jeweils unter Verwendung eines IR-Ultrakurzpulslasers (TruMicro Serie 2000, Trumpf) abgetragen. Diese Beispiele EB-1.1 bis EB-1.5 und VB-1.1 bis VB-1.3 stimmten in folgenden Parametern überein:

Pulsdauer: 3 ps
Fokusdurchmesser des gepulsten Laserstrahls: 55 $\mu$m
Scangeschwindigkeit: 5500 mm/s
Pulsfrequenz: 1 MHz
Pulsüberlapp: 90%
Abstand benachbarter Scanlinien: 25 $\mu$m

Es wurden allerdings die Pulsenergien und Anzahl der Überfahrten der Scanlinien (d.h. wie oft die vorgegebenen Scanlinien mit dem gepulsten Laserstrahl überfahren wurden) variiert, so dass in den erfindungsgemäßen Beispielen EB-1.1 bis EB-1.5 jeweils eine Gesamtfluenz im Bereich von 50-650 J/cm$^2$ appliziert wurde, während in Vergleichsbeispiel VB-1.1 eine geringere Gesamtfluenz und in Vergleichsbeispiel VB-1.2 eine höhere Gesamtfluenz appliziert wurden.

Auch in den erfindungsgemäßen Beispielen EB-2.1, EB-2.2, EB-2.3, EB-2.4 und EB-2.5 sowie den Vergleichsbeispielen VB-2.1 und VB-2.2 wurde die freigelegte Reaktionsschicht jeweils unter Verwendung des IR-Ultrakurzpulslasers (TruMicro Serie 2000, Trumpf) abgetragen. Diese Beispiele EB-2.1 bis EB-2.5 und VB-2.1 bis VB-2.2 stimmten in folgenden Parametern überein:

Pulsdauer: 850 fs
Fokusdurchmesser des gepulsten Laserstrahls: 55 $\mu$m
Scangeschwindigkeit: 1100 mm/s

Pulsfrequenz: 5 MHz
Pulsüberlapp: 90%
Abstand benachbarter Scanlinien: 15 μm

Wiederum wurden die Pulsenergien und Anzahl der Überfahrten der Scanlinien durch den gepulsten Laserstrahl variiert, so dass in den erfindungsgemäßen Beispielen EB-2.1 bis EB-2.5 jeweils eine Gesamtfluenz im Bereich von 50-650 J/cm$^2$ appliziert wurde, während in Vergleichsbeispiel VB-2.1 eine geringere Gesamtfluenz und in Vergleichsbeispiel VB-2.2 eine höhere Gesamtfluenz appliziert wurden.

In Vergleichsbeispiel VB3 wurde die freigelegte Reaktionsschicht mit einer Ätzlösung, die Ammoniumfluorid, Fluorborsäure und Wasserstoffperoxid enthielt, entfernt.

Jede der nach dem Abtragen der Reaktionsschicht erhaltenen strukturierten Metall-Keramik-Verbunde wurde hinsichtlich der folgenden Eigenschaften untersucht:

- Mögliche Rückstände der freigelegten Reaktionsschicht auf dem Keramiksubstrat,
- Biegebruchfestigkeit des Keramiksubstrats,
- Temperaturwechselbeständigkeit des Metall-Keramik-Verbunds.

Die Bewertung der Temperaturwechselbeständigkeit erfolgte durch folgende Testmethode: Zur Vorbereitung des Temperaturwechselbeständigkeitstests wurde zunächst mittels Ultraschallmikroskopie (PVA Tepla SAM300) überprüft, ob die Metall-Keramik-Verbunde in einwandfreiem Zustand waren. Für den Test wurden ausschließlich Metall-Keramik-Verbunde verwendet, die keine Delamination zwischen Keramikkörper und Metallschicht oder sonstige Deformationen, die zur Delamination der Metallschicht vom Keramikkörper führen könnten (zum Beispiel Risse), zeigten. Zum Testen der Temperaturwechselbeständigkeit wurden die Metall-Keramik-Verbunde wiederholt für einen Zeitraum von jeweils fünf Minuten einer kalten Flüssigkeit (Temperatur -65°C, Galden Do2TS) und einer heißen Flüssigkeit (Temperatur +150°C, Galden Do2TS) in einer Zyklierkammer (ESPEC TSB-21 51) ausgesetzt. Die Metall-Keramik-Verbunde wurden alle 1000 Zyklen mittels Ultraschallmikroskopie (PVA Tepla SAM300) erneut auf Delamination und sonstige Deformationen überprüft. Der Test wurde nach 3000 Zyklen beendet. Danach wurden die Metall-Keramik-Verbunde wiederum mittels Ultraschallmikroskopie (PVA Tepla SAM300) auf Delamination und sonstige Deformationen überprüft. Der Zustand der jeweiligen Metall-Keramik-Verbunde nach Durchführung des Temperaturwechselbeständigkeitstests wurde mit dem Zustand der Metall-Keramik-Verbunde vor Durchführung des Temperaturwechselbeständigkeitstests im Hinblick auf eine Delamination und sonstige Deformationen verglichen. Delaminationen und sonstige Deformationen (zum Beispiel Risse) waren hierbei als weiße Verfärbungen im Ultraschallbild erkennbar. Die Ergebnisse wurden wie folgt eingestuft:

Sehr gut: Es waren keine Delaminationen erkennbar
Mangelhaft: An den Ecken des Metall-Keramik-Substrats waren Delaminationen erkennbar

Die Bewertung, wie vollständig die freigelegte Reaktionsschicht entfernt wurde, erfolgte durch Rasterelektronenmikroskopie und EDX.

Für die Messung der Biegebruchfestigkeit wurde ein 3-Punkt-Biegebruchfestigkeit-Werkzeug in die Prüfmaschine eingebaut und ein entsprechendes Prüfrezept nach Norm DIN EN 843-1:2008-08 verwendet. Folgende Prüfparameter wurden eingestellt: Vorkraft 0,5 N, Geschwindigkeit der Vorkraft 0,5 mm/min, Prüfgeschwindigkeit 10 mm/min (lagegeregelt). Aufgrund der Form der Flachsubstrate weichen die hier vorliegenden Probenmaße von den in der Norm beschriebenen Maßen ab. Dennoch ermöglichen diese Parameter den Bruch in der Norm vorgegebenen Zeit nach Beanspruchung (5 bis 15 Sekunden), so dass die Vorgabe der Norm erfüllt ist. Aus den gemessenen Bruchkräften und den Probenmaßen wurde für jede Probe mittels Formel 1 die Bruchspannung σf ermittelt:

$$\sigma_f = \frac{3 \; x \; F \; x \; l}{2 \; x \; b \; x \; h^2}$$

Formel 1: Gleichung zur Berechnung der Bruchspannung of

Dabei ist

σf    die Bruchspannung (in Newton je Quadratmillimeter N x mm-2; äquivalent zu MPa)
F     die Höchstkraft beim Bruch (in Newton N)
b     die Breite des Probekörpers (in Millimeter mm)
h     die Höhe des Probekörpers (in Millimeter mm)

l     der Abstand zwischen den Mittelpunkten der Auflagerollen (in Millimeter mm)

Die Biegebruchfestigkeit wurde wie folgt eingestuft:

Hoch: > 630 MPa
Mittel: 600-630 MPa
Niedrig: < 600 MPa

Die Ergebnisse sind in der nachfolgenden Tabelle 1 zusammengefasst.

Tabelle 1: In den Beispielen applizierte Gesamtfluenzen und Eigenschaften der strukturierten Metall-Keramik-Verbunde

| Beispiel | Gesamtfluenz (J/cm²) | Pulsenergie (µJ) | Anzahl der Überfahrten | Rückstände der freigelegten Reaktionsschicht | Biegebruchfestigkeit | Temperaturwechselbeständigkeit |
|---|---|---|---|---|---|---|
| EB-1.1 | 84 | 50 | 1 | vernachlässigbar gering | hoch | Sehr gut |
| EB-1.2 | 168 | 50 | 2 | keine | hoch | Sehr gut |
| EB-1.3 | 168 | 100 | 1 | Keine | hoch | Sehr gut |
| EB-1.4 | 168 | 25 | 4 | Keine | hoch | Sehr gut |
| EB-1.5 | 336 | 50 | 4 | Keine | mittel | Sehr gut |
| VB-1.1 | 42 | 25 | 1 | nahezu flächendeckend | hoch | Sehr gut |
| VB-1.2 | 674 | 100 | 4 | Keine | niedrig | Sehr gut |
| EB-2.1 | 74 | 25 | 1 | vernachlässigbar gering | Hoch | Sehr gut |
| EB-2.2 | 148 | 50 | 1 | Keine | Hoch | Sehr gut |
| EB-2.3 | 294 | 100 | 1 | Keine | Hoch | Sehr gut |
| EB-2.4 | 294 | 25 | 4 | Keine | Hoch | Sehr gut |
| EB-2.5 | 590 | 50 | 4 | Keine | Mittel | Sehr gut |
| VB-2.1 | 36 | 12,5 | 1 | nahezu flächendeckend | Hoch | Sehr gut |
| VB-2.2 | 1178 | 100 | 4 | Keine | Niedrig | Sehr gut |
| VB3 | - | | | keine | hoch | Mangelhaft |

Die Beispiele zeigen Folgendes:

Erfolgte das Abtragen der freigelegten Reaktionsschicht durch den Ultrakurzpulslaser, zeigten die dabei erhaltenen Metall-Keramik-Verbunde eine sehr gute Temperaturwechselbeständigkeit. Eine vollständige Entfernung der freigelegten Reaktionsschicht unter Beibehaltung einer hohen Biegebruchfestigkeit konnte jedoch nur dann realisiert werden, wenn die durch den Ultrakurzpulslaser applizierte Gesamtfluenz im erfindungsgemäßen Bereich (50-650 J/cm$^2$) lag. Betrug die Gesamtfluenz mehr als 650 J/cm$^2$, führte dies zu einer Beeinträchtigung der Biegebruchfestigkeit, während bei einer Gesamtfluenz von weniger als 50 J/cm$^2$ die freigelegte Reaktionsschicht nicht oder nur ungenügend abgetragen wurde.

Erfolgte das Abtragen der freigelegten Reaktionsschicht durch ein Ätzen, so konnte zwar die Reaktionsschicht vollständig entfernt werden, ohne die Biegebruchfestigkeit zu beeinträchtigen, allerdings zeigte der dabei erhaltene Metall-Keramik-Verbund eine signifikante Abnahme der Temperaturwechselbeständigkeit.

**Patentansprüche**

1.  Ein Verfahren zur Strukturierung eines Metall-Keramik-Verbunds, folgende Schritte umfassend:

    - Bereitstellung eines Metall-Keramik-Verbunds, enthaltend

        - ein Nitridkeramiksubstrat, das eine Vorderseite und eine Rückseite aufweist,
        - eine auf der Vorderseite des Nitridkeramiksubstrats vorliegende Metallbeschichtung,
        - eine Reaktionsschicht, die zwischen der Metallbeschichtung und dem Keramiksubstrat vorliegt und ein oder mehrere Elemente $E_{RS}$, ausgewählt aus Ti, Hf, Zr, Nb, V, Ta und Ce, enthält,

    - Abtragen der Metallbeschichtung, so dass mindestens eine Aussparung in der Metallbeschichtung erzeugt wird und eine freigelegte Reaktionsschicht in der Aussparung vorliegt,
    - Abtragen der freigelegten Reaktionsschicht mit einem gepulsten Laserstrahl eines Ultrakurzpulslasers, so dass eine freigelegte Oberfläche des Keramiksubstrats in der Aussparung vorliegt, wobei der gepulste Laserstrahl eine Gesamtfluenz von 50 J/cm$^2$ bis 650 J/cm$^2$ appliziert.

2.  Das Verfahren nach Anspruch 1, wobei das Nitridkeramiksubstrat ein Siliziumnitrid oder ein Aluminiumnitrid enthält und die Metallbeschichtung eine Kupferbeschichtung oder eine Aluminiumbeschichtung ist.

3.  Das Verfahren nach Anspruch 1 oder 2, wobei das Abtragen der Metallbeschichtung durch ein Ätzen oder eine Laserablation, bevorzugt durch ein Ätzen erfolgt.

4.  Das Verfahren nach einem der vorstehenden Ansprüche, wobei die durch den gepulsten Laserstrahl applizierte Gesamtfluenz 100 J/cm$^2$ bis 320 J/cm$^2$ beträgt.

5.  Das Verfahren nach einem der vorstehenden Ansprüche, wobei der gepulste Laserstrahl Pulse mit einer Pulsdauer von 1 Femtosekunde bis 100 Picosekunden aufweist.

6.  Das Verfahren nach einem der vorstehenden Ansprüche, wobei der gepulste Laserstrahl Pulse aufweist, deren Pulsenergie jeweils mindestens 15 $\mu$J beträgt.

7.  Das Verfahren nach einem der vorstehenden Ansprüche, wobei der gepulste Laserstrahl eine Pulsfrequenz $f_L$ von 100 kHz bis 50 MHz aufweist.

8.  Das Verfahren nach einem der vorstehenden Ansprüche, wobei der auf die freigelegte Haftvermittlungsschicht auftreffende gepulste Laserstrahl einen Durchmesser $D_L$ von 3 $\mu$m bis 200 $\mu$m aufweist.

9.  Das Verfahren nach einem der vorstehenden Ansprüche, wobei der gepulste Laserstrahl der folgenden Bedingung genügt:

$$(1 - v_{scan} / (D_L \times f_L)) \times 100\% \geq 60\%$$

wobei

$v_{scan}$ die Scangeschwindigkeit des gepulsten Laserstrahls ist,

$D_L$ der Durchmesser des auf die freigelegte Haftvermittlungsschicht auftreffenden gepulsten Laserstrahls ist,

$f_L$ die Pulsfrequenz des gepulsten Laserstrahls ist.

Europäisches
Patentamt

European
Patent Office

Office européen
des brevets

# EUROPÄISCHER RECHERCHENBERICHT

**Nummer der Anmeldung**

EP 24 21 4378

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2019 135099 A1 (ROGERS GERMANY GMBH [DE]) 24. Juni 2021 (2021-06-24) | 1-4,6-9 | INV. C04B37/02 |
| A | * Absätze [0013], [0018], [0025] - [0027], [0039], [0042] *<br>* Abbildungen 1-3 * | 5 | C04B41/53<br>H01L21/306<br>C04B41/00<br>C04B41/91 |
| | - - - - - | | |
| X | EP 3 599 636 B1 (BOSCH GMBH ROBERT [DE]) 14. September 2022 (2022-09-14)<br>* Absätze [0014], [0025] - [0028]; Abbildungen 1,2 * | 1-3 | |
| | - - - - - | | |
| X | CN 111 704 479 A (OPPO GUANGDONG MOBILE TELECOMMUNICATIONS CO LTD) 25. September 2020 (2020-09-25)<br>* Absätze [0017], [0024] - [0026], [0035], [0053] - [0059] *<br>* Anspruch 9 * | 1-9 | |
| | - - - - - | | |
| A | US 2019/385926 A1 (NABA TAKAYUKI [JP] ET AL) 19. Dezember 2019 (2019-12-19)<br>* Absätze [0077] - [0087] * | 1-9 | |
| | - - - - - | | **RECHERCHIERTE SACHGEBIETE (IPC)** |
| A | US 2010/032143 A1 (DATTA MADHAV [US] ET AL) 11. Februar 2010 (2010-02-11)<br>* Absätze [0050] - [0051]; Anspruch 6; Abbildungen 9-11 * | 1-9 | C04B<br>H01L |
| | - - - - - | | |
| A | CN 117 043 934 A (ROGERS GERMANY GMBH) 10. November 2023 (2023-11-10)<br>* Ansprüche 4-5 * | 1-9 | |
| | - - - - - | | |

Der vorliegende Recherchenbericht wurde für alle Patentansprüche erstellt

| Recherchenort | Abschlußdatum der Recherche | Prüfer |
|---|---|---|
| Den Haag | 12. Februar 2025 | Sow, Eve |

EPO FORM 1503 03.82 (P04C03)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

 

& : Mitglied der gleichen Patentfamilie, übereinstimmendes Dokument

**ANHANG ZUM EUROPÄISCHEN RECHERCHENBERICHT
ÜBER DIE EUROPÄISCHE PATENTANMELDUNG NR.**　　　EP 24 21 4378

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-02-2025

| Im Recherchenbericht angeführtes Patentdokument | Datum der Veröffentlichung | Mitglied(er) der Patentfamilie | Datum der Veröffentlichung |
|---|---|---|---|
| DE 102019135099 A1 | 24-06-2021 | DE 102019135099 A1 | 24-06-2021 |
| | | EP 4021869 A1 | 06-07-2022 |
| | | JP 7400109 B2 | 18-12-2023 |
| | | JP 2023506558 A | 16-02-2023 |
| | | WO 2021122035 A1 | 24-06-2021 |
| EP 3599636 B1 | 14-09-2022 | DE 102018212272 A1 | 30-01-2020 |
| | | EP 3599636 A1 | 29-01-2020 |
| CN 111704479 A | 25-09-2020 | KEINE | |
| US 2019385926 A1 | 19-12-2019 | CN 110313064 A | 08-10-2019 |
| | | CN 118098990 A | 28-05-2024 |
| | | EP 3608951 A1 | 12-02-2020 |
| | | EP 4401128 A2 | 17-07-2024 |
| | | JP 7204637 B2 | 16-01-2023 |
| | | JP 7451638 B2 | 18-03-2024 |
| | | JP 2022177207 A | 30-11-2022 |
| | | JP WO2018173921 A1 | 30-01-2020 |
| | | US 2019385926 A1 | 19-12-2019 |
| | | US 2023154826 A1 | 18-05-2023 |
| | | WO 2018173921 A1 | 27-09-2018 |
| US 2010032143 A1 | 11-02-2010 | CN 102171378 A | 31-08-2011 |
| | | CN 102171897 A | 31-08-2011 |
| | | US 2010032143 A1 | 11-02-2010 |
| | | US 2010035024 A1 | 11-02-2010 |
| | | WO 2010017321 A1 | 11-02-2010 |
| | | WO 2010017327 A1 | 11-02-2010 |
| CN 117043934 A | 10-11-2023 | CN 117043934 A | 10-11-2023 |
| | | DE 102021107690 A1 | 29-09-2022 |
| | | EP 4315418 A1 | 07-02-2024 |
| | | JP 2024510808 A | 11-03-2024 |
| | | KR 20230150354 A | 30-10-2023 |
| | | US 2024178098 A1 | 30-05-2024 |
| | | WO 2022200406 A1 | 29-09-2022 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **N. CHASSERIO et al.** Ceramic Substrates for High-Temperature Electronic Integration. *Journal of Electronic Materials*, 2009, vol. 38, 164-174
- **K. HIRAO et al.** High Thermal Conductivity Silicon Nitride Ceramics. *Journal of the Korean Ceramic Society*, 2012, vol. 49, 380-384
- **Y. ZHOU et al.** Development of high-thermal-conductivity silicon nitride ceramics. *Journal of Asian Ceramic Societies*, 2015, vol. 3, 221-229
- Aktivlöten. Brevier Technische Keramik, Verband der Keramischen Industrie. Fahner Verlag, 2003, 203-204
- **A. PÖNICKE et al.** Aktivlöten von Kupfer mit Aluminiumnitrid- und Siliziumnitridkeramik. *Keramische Zeitschrift*, 2011, vol. 63 (5), 334-342